Europäisches Patentamt

European Patent Office

Office européen des brevets

(11) Publication number: **0 162 181**

**A1**

(12) **EUROPEAN PATENT APPLICATION**

(21) Application number: **84830128.9**

(22) Date of filing: **24.04.84**

(51) Int. Cl.⁴: **H 01 R 13/514**
 H 02 B 1/10, H 05 K 7/14

(43) Date of publication of application:
 **27.11.85 Bulletin 85/48**

(84) Designated Contracting States
 **AT BE CH DE FR GB IT LI LU NL SE**

(71) Applicant: **BASSANI TICINO S.p.A.**
 **Corso di Porta Vittoria, 9**
 **I-20122 Milano (IT)**

(72) Inventor: **Bonetalli, Angelo**
 **Via Sardegna, 10**
 **I-24100 - Bergamo (IT)**

(74) Representative: **La Ciura, Salvatore**
 **Via Francesco Sforza 5**
 **I-20122 Milano (IT)**

(54) **A method of installing modular electric devices.**

(57) The invention relates to a method of installing modular electric devices direct on external support plates, or the like, which are provided with windows (13), wherein the electric devices are inserted in the direction of the major axis of said windows (13) by axial sliding means (16, 17) and (16', 17'), provided on the sidewalls of the windows (13) and on the sidewalls of the electric device respectively.

EP 0 162 181 A1

- 1 -

A METHOD OF INSTALLING MODULAR ELETRIC DEVICES

Technical Field

This invention relates to a method of installing electric devices direct on external support plates, or the like, in a quick manner.

Background Art

Systems are known to install electric devices (also referred to as 'fruits' hereinafter) direct on external plates, panels, bases, and the like, without the use of any auxiliary support frame being required.

According to a technique known, the 'fruits' are mounted by introducing them into windows provided in a support plate, or the like, from a front side thereof. Fastening of the 'fruits' is usually performed from the rear side, by means of a rectangle-shaped, elastic strip of metal material, which surrounds the housing of the associated 'fruit' and is provided with dogs that bite into the material of the housing so as to abut against the back face of the support.

Such a method, in addition to being very complicated, never is able to ensure that the 'fruit' is fastened in a very

0162181

reliable manner. Moreover, it has many disadvantages in that, for example, the metal strip is likely to be put in tension due to a wire-lead having become detached or,when the device is a current tap, the risk exists for the enti re device to be pulled out upon withdrawing the associated plug.

There are however other fastening methods not utilizing an elastic metal strip, so that some disadvantages typical of the use of said strip are avoided, but here again comple te avoidance of the above said disadvantages connected with the mentioned mounting method - that is introduction of the 'fruit' into the respective window in the support plate from the front side thereof - is not achieved.

These other methods of fastening the 'fruit' to the plate utilize interengaging means which consist of resilient lugs carried by the support plate and provided with teeth or dogs designed to enter corresponding recesses in the 'fruit' housing.

It is apparent, therefore, that the risk still exists, particularly in the case of a current tap, for the device to be ejected from the rear of the support plate, or pulled out of the front thereof, if the plug pins are received with some fitting interferences in the tap holes.

The above drawbacks become the more significant when considering that fastening reliability of the device relies on skill and accuracy of an installer.

- 3 -

It has moreover to be considered that, at least for removing the 'fruits", the use of a tool is required, and this has to work direct on the housing of the concerned 'fruit', which involves problems as is well known.

## Disclosure of the invention

This invention permits all of the above disadvantages to be eliminated by providing a method of mounting an electric device on a support plate direct, which method well distinguishes from the conventional method of inserting the device into a window in a support plate from the front (or the rear) side thereof.

By the method according to the invention, the risk of an unre-liable installation is entirely avoided, since the installa-tion does not rely upon the skill of an installer. Moreover, there is no need to use a tool for mounting the device on its support or removing it therefrom.

The mounting method according to the invention is characterized in that the electric device, or the so called 'fruit', is mounted in the window in a respective support plate by introducing it in the direction of the major axis of said window. In order to do so, the support plate is formed of two single parts, namely one lower part that is provided with a row of open-top windows, and one upper part that is designed to be located on the lower part so as to complete the support plate. The sidewalls of the windows are formed with vertical opposite grooves extending away from the top ends of said walls and serving as guides for the 'fruits' to be inserted, which latter are provided on their sidewalls with corresponding projections designed to engage said grooves.

In order to fit the support plate to a wall, a rectangle-shaped support frame is provided and is preferably symmetrical with respect to its major axis, said support frame having recesses and abutting means provided over its internal boundary faces and designed to releasably engage with corresponding means carried by the two parts of the support plate.

The support frame is fastened to an associated wall flush box, or it may even be built on the front edge of this latter.

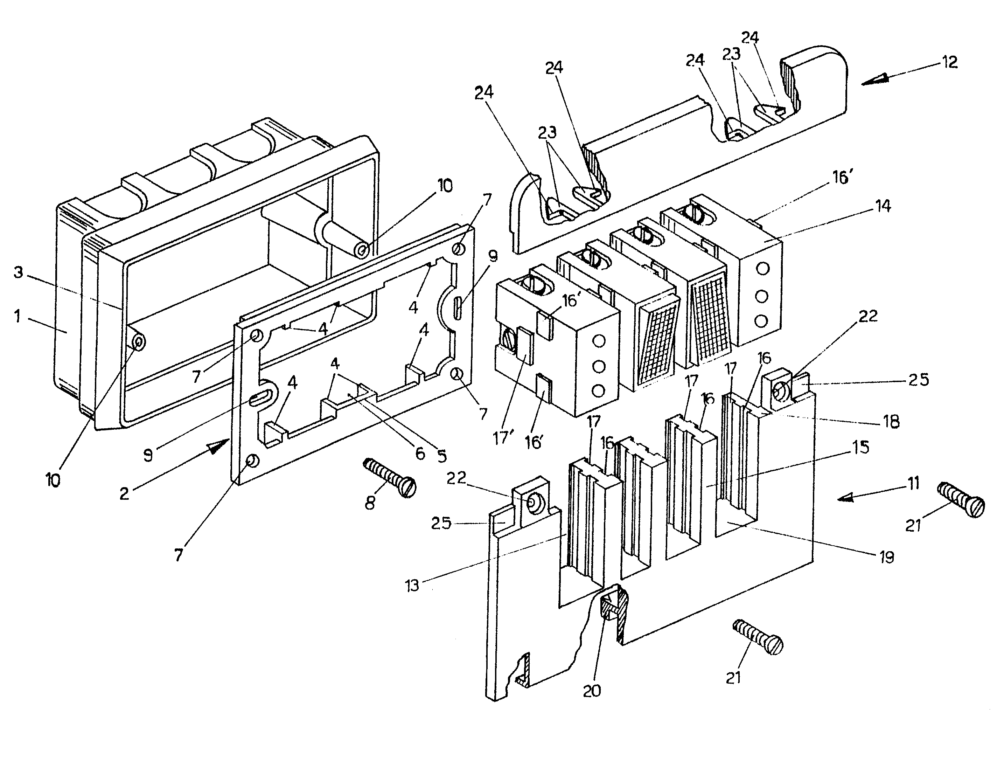

Further features of the method for installing modular, composable electric devices according to the invention are best understood with the aid of the following description of one embodiment thereof, which is shown, as a non-restrictive example, in the single figure of the accompanying drawing, the figure being an exploded, partially sectional view of a mounting system for carrying out the method according to the invention.

Best mode of carrying out the invention

Reference will be made now to the above figure, in which there is indicated by 1 a conventional type of wall flush box designed to receive in the interior thereof the electric devices to be installed. The reference numeral 2 indicates a rectangle-shaped frame, which will be also referred to as the support frame, although by this term it is usually meant a frame on which electric devices or 'fruits' are mounted direct.

According to the invention, the support frame 2 only serves the purpose of fastening the support plate, and could even be built direct on the front edge 3 of the flush box 1 to be integral with this latter.

The support frame 2 may be considered as to be substantially symmetrical to its own principal axes, and this in order to have it fit on the corresponding flush box in a simpler manner. Provided inside each horizontal side (see figure of the accompanying drawing) of the frame 2, are small vertical paral lel partition walls 4, of which the ones located at the centre form, together with a rising portion 5 of the internal edge of the frame, a U-shaped recess 6. Holes 7 are formed in the four corners of the frame, and two of these holes 7 are intended to receive screws therein for fastening the support plate, as will be explained herein below.

The frame 2 is fastened to the flush box 1 by means of a pair of screws 8 (only one shown) which are passed in elongated holes 9 in the sidewalls of the frame and then driven into holes 10 provided inside the sidewalls of the flush box 1. One of the two elongated openings 9 is horizontally directed and the other one is arranged vertically so that it is ensured that the frame is located on the associated flush box in accurate registering relationship therewith.

0162181

According to a basic feature of this invention, the support plate for supporting the electric devices is constructed from two separated parts that are indicated by 11 and 12 in the drawing. The lower part 11 serves as a support proper for the 'fruits' to be installed, while the upper part 12, that is of significatly smaller size than said part 11, serves the purpose of holding the 'fruit' against any movement in a vertical direction, and it also gives the plate a finish appearance.

The lower part 11 of the support plate has a row of windows 13 provided therein with each window being designed to receive a corresponding 'fruit' or electric component 14. In the example shown, there are four windows and four corresponding components, namely two sockets and two switches, but it is clearly apparent that the windows may be different in number and that the window row also may comprise only one window, and that, likewise, different types of electric devices such as, for example, changeover switches, pushbuttons, pilot lights, electric bells, fuse carriers, etc., may be housed therein, according to a well known technique of construction of modular, interchangeable electric devices.

If the plate windows are greater in number than are the 'fruits' that it is desired to mount at the time of installation, then the empty windows are filled with 'false fruits', that is to say fruit housings with no 'fruit' therein.

As is shown in the figure, the plate windows 13 have no top portions so that they are open upwardly. Provided in each

sidewall 15 of windows 13 is a pair of vertically directed, front and rear parallel grooves 16 and 17, respectively, which are in facing relationship with the pair of grooves in the opposite wall. Said grooves extend throughout the height of the corresponding wall from the upper edge 18 down to the base 19 of the respective window.

Likewise, each device or 'fruit' 14 has on the sidewall thereof, one or more vertically aligned projections 16' which are designed to engage with the corresponding grooves 16 of a respective window 13, and at least one projection 17' for engagement with a corresponding groove 17. It should be apparent that the projections 16' and 17' could be designed so as to be continuous all along the length of the sidewalls of the concerned 'fruit'.

A 'fruit' 14 is thus fitted to the support plate by introducing the 'fruit' into a corresponding window 13 from the above, the projections 16' and 17' being caused to slip down the grooves 16 and 17 that serve as guides for them.

Once the 'fruit' having been mounted on part 11 of the support plate, this plate part is fastened to the frame 2 by causing a dog formation 20 provided at a rear central location near the bottom edge of said part, to engage with the U-shaped recess 6 in said frame 2, after which the plate part 11 is secured at the top by means of screws 21. The screws 21 are passed through screw holes 22 in the upper ends of part 11 of the support plate, and then driven into a pair of the holes 7 in the frame 2.

0162181

In order to fasten the upper part 12 of the support plate, this latter part is provided at the back thereof with resilient lugs 23 that are arranged in pairs and have dog-like formations in opposite relationship to one another, said dogs being designed to engage, following to elastic deformation of lugs 23, with the back of the partition walls 4 provided on the associated horizontal side of frame 2.

Withdrawing of the upper part 12 of the plate is achieved by levering, by means of a tool such as, for example, the sharp edge of a screwdriver, at a relief region 25 - that is formed when coupling together the two parts of the plate- until resistance of the resiliently engaging means 23 - 24 is overcome.

Obviously, all of the components of the mounting system described above, except perhaps the screws 8 and 21, are made from plastic material.

It should be apparent that the method of the invention eliminates all of the drawbacks that are typical of the prior art mounting methods which provided for the 'fruits' to be inserted into the windows in the plate from the front (or the rear) thereof.

In fact, by the design of the present mounting system, there is suppressed the risk that an electriccomponent, such as, for example, a current tap, may be either ejected to the rear or pulled out of the front of a corresponding window in the support plate as a result of the exertion of a great

0162181

er force than the retaining force exerted by the fruit-plate engaging means.

Also, both the operations of mounting and removing the 'fruits' are made easier, since no tool is required to be used for performing said operations.

Furthermore, the risk of inaccurate installation is elimi nated as well, since the installer cannot help causing the projections 16' and 17' to slip down the respective guiding grooves 16 and 17 in order to perform the mounting operation.

It will be appreciated that many changes, as to the details of construction, may be made to the method of this invention for installing electric devices direct on a support plate, without departing from the spirit and scope of the invention itself.

Claims

## Claims

1. A method of installing modular, interchangeable electric devices, or so called 'fruits', direct on an external support plate or the like which is provided with windows (13) arranged in a row side by side, characterized in that the 'fruits' are inserted in a direction of the major axis of said windows (13) by cooperation with means ensuring an axial sliding engagement therewith.

2. The method according to claim 1, characterized in that the support plate is formed of two separated parts, said separated parts comprising a lower part (11) that is provided with the row of windows (13) with said windows being open at the top in order to allow for the 'fruits' (14) to be inserted from the above, and an upper part (12) that is normally smaller in height than said lower part (11).

3. The method according to claims 1 and 2 characterized in that the sidewalls of the windows (13) are each provided with a pair of vertical, parallel grooves (16, 17) that are in facing relationship with corresponding grooves (16, 17) in the opposite side of each window (13), the sidewalls of the 'fruits' (14) being each provided with projections (16',17') that are designed to engage the grooves (16, 17) respectively of the associated windows.

4. The method according to claims 1 and 3, characterized in that said projections (16', 17') are discontinuous projections.

5. The method according to claims 1 and 3, characterized in that said projections are continuous projections and they extend all along the length of the sidewalls of the 'fruits' (14).

6. The method according to claim 1 and to one or more of the claims 2 to 5, characterized in that a rectangle-shaped frame (2) is provided for fastening the parts (11, 12) of the support plate, said frame (2) having a hole (7) provided in each corner thereof, while inside two opposite sides of frame (2) this latter is provided with a U-shaped recess (6) and with shallow partition walls (4) that are orthogonal to the plane of the frame, the arrangement being such that the lower part (11) of the plate is fastened to the frame (2) by causing a dog formation (20) carried on the back side, near the bottom edge of said part (11), to fit into said U-shaped recess (6), after which screws (21) are passed through screw holes (22) in the part (11) of the plate, and driven into two of the holes (7) in the frame (2).

7. The method of claim 1 and one or more of claims 2 to 6, wherein, provided on the back side of the upper part (12) of the support plate are resilient lugs (23) that are arranged in pairs and have dog formation (24) at their opposite ends, said dogs being designed to engage, following to elastic deformation of lugs (23), with the back face of the partition walls (4) provided on the frame (2).

8. The method according to claims 1 and 6, characterized in that said frame (2) is symmetrical with respect to the main axes thereof.

9. The method according to claims 1 and 6, characterized in that said frame (2) is fastened to a flush box (1) by the aid of two screws (8) that are passed through elongated openings (9) in the sides of the frame and being driven into recesses (10) provided inside the sidewalls of box (1), the two elongated openings (9) having their major axes orthogonal to one another.

10. The method according to claims 1 and 6, characterized in that said frame (2) is built on the front edge (3) of the flush box (1) to be a single unit therewith.

11. The method according to claim 1 and one or more of claims 2 to 10, wherein at least one relief means (25) is provided in the coupling together of parts (11, 12) of the support plate, said relief means (25) allowing for the insertion of the point of a tool therein when said part (12) of the plate is to be withdrawn.

12. The method of installing modular, interchangeable electric devices or 'fruits', according to claim 1, wherein said support plate only comprises said lower part (11).

0162181

European Patent
Office

**EUROPEAN SEARCH REPORT**

## DOCUMENTS CONSIDERED TO BE RELEVANT

| Category | Citation of document with indication where appropriate, of relevant passages | Relevant to claim | CLASSIFICATION OF THE APPLICATION (Int. Cl.4) |
|---|---|---|---|
| A | EP-A-0 037 013 (SIEMENS)<br>* Claims 1-5,8; figures 1-4 * | 1-3,5 | H 01 R 13/514<br>H 02 B 1/10<br>H 05 K 7/14 |
| A | US-A-4 093 970 (M'SADOQUES et al.)<br>* Column 2, line 30 - column 3, line 50; figures 1-4 * | 1 | |
| A | DE-A-2 208 752 (HENNIG)<br>* Claims 1,4; figures 1-4 * | 1 | |
| A | US-A-4 090 764 (MALSBY et al.)<br>* Column 2, line 47 - column 9, line 13; figures 1-19 * | | |

TECHNICAL FIELDS
SEARCHED (Int. Cl.4)

H 01 R 13/514
H 02 B 1/04
H 02 B 1/08
H 02 B 1/10
H 05 K 7/14

The present search report has been drawn up for all claims

| Place of search | Date of completion of the search | Examiner |
|---|---|---|
| BERLIN | 07-12-1984 | HAHN G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82